# EUROPEAN PATENT APPLICATION

(11) **EP 1 873 840 A1**
(43) Date of publication of application: **02.01.2008**
(21) Application number: 07110609.0
(22) Date of filing: 20.06.2007
(51) Int. Cl.: H01L 31/0352, H01L 31/068, H01L 31/20, H01L 29/36, H01L 31/0236

(54) **Photovoltaic device which includes all-back-contact configuration; and related fabrication processes**

(30) Priority: 30.06.2006 US 480161
(71) Applicant: General Electric Company, Schenectady, NY 12345 (US)
(72) Inventor: Johnson, James Neil, Scotia, NY 12302 (US); Manivannan, Venkatesan, Rexford, NY 12148 (US)
(74) Representative: Szary, Anne Catherine

(57) **Abstract**

A semiconductor structure is described, which includes a semiconductor substrate (10) of one conductivity type, having a front surface (12) and a back surface (14). A first amorphous semiconductor layer (16) is applied on the front surface (12); and second (22) and third (32) amorphous semiconductor layers are disposed on portions of the back surface (14) of the substrate (10). The second and third layers are each compositionally graded through their depth, from substantially intrinsic at the interface with the substrate (10), to substantially conductive at their opposite surfaces. In some instances, the first semiconductor layer (16) is also compositionally graded, while in other instances, it is intrinsic in character. The semiconductor structures can function as solar cells; and modules which include a number of such cells represent another embodiment of the invention. Methods for making a photovoltaic device are also described..

## Description

### BACKGROUND OF THE INVENTION

This invention relates generally to high efficiency solar cells. More specifically, the invention relates to solar cells based on semiconductor devices which include a heterojunction.

There is no doubt that solar energy offers the potential for providing virtually unlimited energy for use by man, if the solar energy can be made available in a useful form. Perhaps the greatest effort so far as been in using the sun's energy to obtain electricity, which can then be utilized through any existing electrical network - on the household, community, or industrial level. A primary approach to generating this electricity from solar radiation has involved direct generation by way of photovoltaic converters. These types of devices rely on the presence of a heterojunction, and are well-known in the art. (As used in this context, a heterojunction is a semiconductor junction which is composed of layers of dissimilar semiconductor material. These materials usually have non-equal band gaps. As one example, a heterojunction can be formed by contact between a layer or region of one conductivity type with a layer or region of opposite conductivity, e.g., a "p-n" junction). In addition to solar cells, other devices which utilize the heterojunction include thin film transistors and bipolar transistors.

In general, photovoltaic devices convert radiation, such as solar, incandescent, or fluorescent radiation, into electrical energy. Sunlight is the typical source of radiation for most devices. The conversion to electrical energy is achieved by the well-known photovoltaic effect. According to this phenomenon, radiation striking a photovoltaic device is absorbed by an active region of the device, generating pairs of electrons and holes, which are sometimes collectively referred to as photo-generated charge carriers.

The electrons and holes diffuse, and are collected by the electric field built into the device.

In view of the potential for solar cells to serve as such a reliable form of clean, renewable energy, great efforts have been made to increase their performance. One primary measurement for such performance is the photoelectric conversion efficiency of the device. Conversion efficiency is usually measured as the amount of electrical current generated by the device, as a proportion of the light energy which contacts its active surface. As documented in the literature, extremely small increases in photoelectric conversion efficiency, e.g., 1% or less, represent very significant advances in photovoltaic technology.

The performance of photovoltaic devices depends in large part on the composition and microstructure of each semiconductor layer. For example, defect sites which result from structural imperfections or impurity atoms may reside on the surface or within the bulk of monocrystalline semiconductor layers. Moreover, polycrystalline semiconductor materials may contain randomly-oriented grains, with grain boundaries which induce a large number of bulk and surface defect sites.

The presence of various defects of this type can be the source of deleterious effects in the photovoltaic device. For example, many of the charge carriers recombine at the defect sites near the heterojunction, instead of continuing on their intended pathway to one or more collection electrodes. Thus, they become lost as current carriers. Recombination of the charge carriers is one of the chief reasons for decreased photoelectric conversion efficiency.

The negative effects of surface defects can be minimized to some degree by passivation techniques. For example, a layer of intrinsic (i.e., undoped) amorphous semiconductor material can be formed on the surface of the substrate. The presence of this intrinsic layer decreases the recombination of charge carriers at the substrate surface, and thereby improves the performance of the photovoltaic device.

The use of this type of intrinsic layer is generally described in U.S. Patent 5,213,628 (Noguchi et al). Noguchi describes a photovoltaic device which includes a monocrystalline or polycrystalline semiconductor layer of a selected conductivity type. A substantially intrinsic layer of 250 Angstroms or less is formed over the substrate. A substantially amorphous layer is formed over the intrinsic layer, having a conductivity opposite that of the substrate, and completing a "semiconductor sandwich structure." The photovoltaic device is completed by the addition of a light-transparent electrode over the amorphous layer, and a back electrode attached to the underside of the substrate.

The photovoltaic devices described in the Noguchi patent appear to considerably minimize the problem of charge carrier recombination in some situations. For example, the presence of the intrinsic layer at selected thicknesses is said to increase the photoelectric conversion efficiency of the device. Moreover, the concept of passivating the surfaces of semiconductor substrates in this manner has been described in a number of references since the issuance of Noguchi et al. Examples include U.S. Patent 5,648,675 (Terada et al); and U.S. Patent Publications 2002/0069911 A1 (Nakamura et al): 2003/0168660 A1 (Terakawa et al); and 2005/0062041 A1 (Terakawa et al).

While the references mentioned above address the recombination problem to some degree, there are some considerable drawbacks remaining. For example, the presence of the intrinsic layer, while beneficial, results in the formation of yet another interface, i.e., between the intrinsic layer and the overlying amorphous layer. This new interface is yet another site for impurities and spurious contaminants to become trapped and to accumulate, and possibly cause additional recombination of the charge carriers. As an example, interruptions between the deposition steps during fabrication of a multilayer structure can provide unwelcome opportunities for the entry of the contaminants. Moreover, abrupt band bending at the interface, due to a change in conductivity, and/or variations in band gap, can lead to a high density of interface states, which is another possible source of recombination.

Furthermore, while the elimination of charge carrier recombination certainly increases photoelectric conversion efficiency, there are other factors which can still decrease the performance of conventional solar cells. As an example, solar cells in the past have often been produced with many of the electrical connections on the front-side of the cell, i.e., the surface receiving incident light. Thus, the front surface of the cell usually included front-side metal grid lines or current collection ribbons, along with associated devices and hardware, such as bus bars and tabs.

The presence of these features on the front-side of a solar cell can be disadvantageous for a number of reasons. For example, the grid lines and tabs detract from the uniformity and overall appearance of the solar cell. Aesthetic features for the solar cells often represent critical quality parameters, e.g., in residential home design. Moreover, the operational performance of the solar cell can be adversely affected by the presence of these front-side features, since they "shade" portions of the incident light which would otherwise be absorbed by the cell.

The various problems associated with front surface features in solar cells have been addressed with some success. For example silicon photovoltaic devices with all of the electrical connections on the back side of the cell have been developed. As described in U.S. Patent 5,053,083 (Sinton), the "back side"-type of cell can exhibit increased efficiency - primarily because of the lack of front-side features which block the desired light energy. Moreover, the absence of these features can facilitate other treatments and operations on the front-side of the cell, e.g., texturing applications, as described below.

Nevertheless, the drive to increase photoelectric efficiency continues to be relentless, since efficiency directly affects the economic viability of photovoltaic devices. Thus, improved photovoltaic devices would be very welcome in the art. The devices should minimize the problem of charge-carrier recombination at various interface regions between semiconductor layers. Moreover, the devices should exhibit electrical properties which ensure good photovoltaic performance, e.g., photoelectric conversion efficiency. Furthermore, the devices should be capable of being made efficiently and economically.

The fabrication of the devices should eliminate process steps which would allow the entry of excessive levels of impurities and other defects. Another important requirement for many of these devices is their visual features. Specifically, the solar cell structure should be aesthetically pleasing and stylish when used in certain applications, e.g., architectural designs for homes and other structures.

### BRIEF DESCRIPTION OF THE INVENTION

One embodiment of this invention is directed to a semiconductor structure, comprising:
(a) a semiconductor substrate of one conductivity type, having a front surface and a back surface;
(b) a first amorphous semiconductor layer disposed on the front surface of the semiconductor substrate;
(c) a second amorphous semiconductor layer disposed on a portion of the back surface of the semiconductor substrate, wherein the second amorphous semiconductor layer is compositionally graded through its depth, from substantially intrinsic at the interface with the substrate, to substantially conductive at the opposite side, said second amorphous semiconductor layer having a selected conductivity type obtained by the incorporation of selected dopant atoms; and
(d) a third amorphous semiconductor layer disposed on another portion of the back surface of the semiconductor substrate, and spaced from the second amorphous semiconductor layer, wherein the third amorphous semiconductor layer is compositionally graded through its depth, from substantially intrinsic at the interface with the substrate, to substantially conductive at the opposite side, said third amorphous semiconductor layer having a conductivity type different from that of the second amorphous layer, and obtained by the incorporation of selected dopant atoms.

Another embodiment of the invention is directed to a solar module, comprising one or more solar cell devices, wherein at least one of the solar cell devices comprises the semiconductor structure described herein.

A method for making a photovoltaic device constitutes another embodiment of this invention. The method comprises the steps of:
(I) forming a first amorphous semiconductor layer over a front surface of a semiconductor substrate;
(II) forming a second amorphous semiconductor layer on a portion of a back surface of the semiconductor substrate, by continuously depositing semiconductor material and a dopant over the back surface portion, while altering the concentration of the dopant, so that the second amorphous semiconductor layer becomes compositionally-graded through its depth, from substantially intrinsic at the interface with the back surface of the substrate, to substantially conductive at the opposite side;
(III) forming a third amorphous semiconductor layer on another portion of the back surface of the semiconductor substrate, by continuously depositing semiconductor material and a dopant over the back surface portion, while altering the concentration of the dopant, so that the third amorphous semiconductor layer becomes compositionally-graded through its depth, from substantially intrinsic at the interface with the back surface of the substrate, to substantially conductive at the opposite side.

Various features, aspects, and advantages of this invention will become more apparent from the following detailed description, taken in conjunction with the accompanying drawings.

### BRIEF DESCRIPTION OF THE DRAWINGS

FIG. 1 is a schematic cross-section which depicts the structure of a photovoltaic device according to one embodiment of the present invention.

FIG. 2 is a schematic cross-section which depicts the structure of a photovoltaic device according to another embodiment of the present invention.

FIG 3 is a schematic cross-section which depicts the structure of a photovoltaic device according to still another embodiment of the present invention.

### DETAILED DESCRIPTION OF THE INVENTION

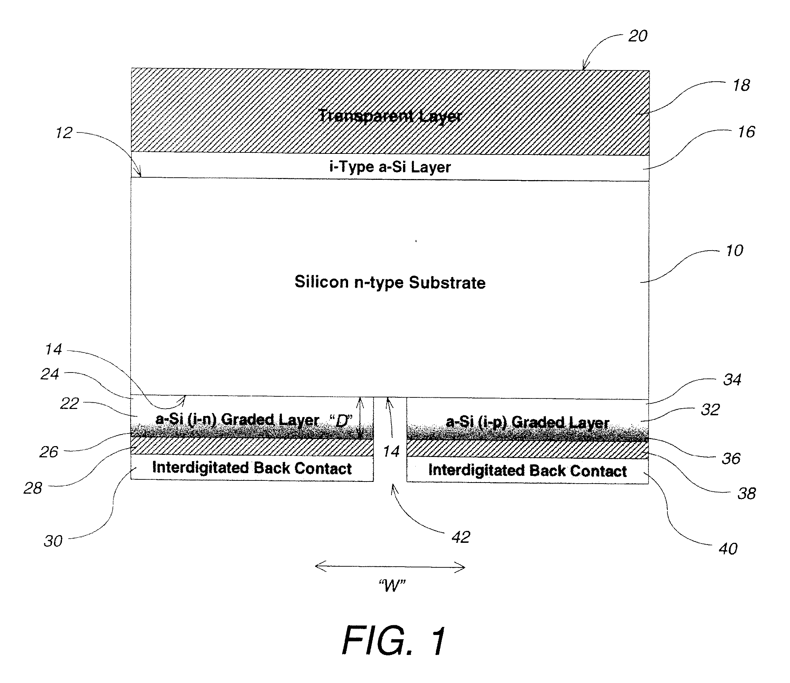

The silicon substrate of this invention can be in a variety of forms. As depicted in FIG. 1, substrate 10 can be monocrystalline or polycrystalline. Furthermore, the substrate material can be n-type or p-type, depending in part on the electrical requirements for the photovoltaic device. Substrate 10 includes a front surface 12, and a back surface 14. The substrate usually has a thickness of about 50 microns to about 600 microns. (It should be understood that all of the figures provided herein are not necessarily drawn to scale, and are instead drawn for easier understanding of the text).

A variety of conventional treatment steps are usually carried out on the substrate, prior to deposition of the other semiconductor layers. For example, the substrate can be cleaned and placed in a vacuum chamber (e.g., a plasma reaction chamber, as described below). The chamber can then be heated to temperatures sufficient to remove any moisture on or within the substrate. Usually, a temperature in the range of about 120-240 °C is sufficient. Sometimes, hydrogen gas is then introduced into the chamber, and the substrate is exposed to a plasma discharge, for additional surface-cleaning. However, many variations on cleaning and pretreatment steps are possible. Usually, these steps are carried out in the chamber used for additional fabrication of the device.

The various semiconductor layers formed over the substrate are usually (though not always) applied by plasma deposition. Many different types of plasma deposition are possible. Non-limiting examples include chemical vapor deposition (CVD); vacuum plasma spray (VPS); low pressure plasma spray (LPPS), plasma-enhanced chemical-vapor deposition (PECVD), radio-frequency plasma-enhanced chemical-vapor deposition (RFPECVD); expanding thermal-plasma chemical-vapor deposition (ETPCVD); electron-cyclotron-resonance plasma-enhanced chemical-vapor deposition (ECRPECVD), inductively coupled plasma-enhanced chemical-vapor deposition (ICPECVD), and air plasma spray (APS). Sputtering techniques can also be used, e.g., reactive sputtering. Moreover, combinations of any of these techniques might also be employed. Those skilled in the art are familiar with the general operating details for all of these deposition techniques. In some preferred embodiments, the various semiconductor layers are formed by a PECVD process.

In one embodiment of this invention depicted in FIG. 1, an intrinsic amorphous silicon layer 16 is formed on the front surface 12 of substrate 10. As mentioned previously, intrinsic layer 16 is un-doped (i.e., having a dopant concentration of substantially zero). The layer can be formed in a number of ways. As a non-limiting example, silicon substrate 10 could be placed in a plasma reaction chamber (e.g., CVD or PECVD). After evacuating the chamber, the substrate could be heated to an appropriate temperature, e.g., about 120°C to about 240°C. A silicon-containing gas, such as silane, is pumped into the chamber as a plasma is generated, e.g., by glow discharge. The plasma causes decomposition of the gaseous precursor, resulting in formation of the amorphous layer of silicon.

The thickness of intrinsic layer 16 will depend on various factors, including the optical and electrical characteristics of the layer. The thickness of the layer is influenced most heavily by the extent to which the recombination of charge carriers at the substrate interface has to minimized. Usually, the thickness of layer 16 is less than or equal to about 250 Angstroms. In some specific embodiments, layer 16 has a thickness in the range of about 30 Angstroms to about 180 Angstroms. The most appropriate thickness in a given situation can be determined without undue effort, e.g., by taking measurements related to the photoelectric conversion efficiency of photovoltaic devices which incorporate the semiconductor.

According to this embodiment, a transparent film or layer 18 is disposed on intrinsic amorphous silicon layer 16, on the light-receiving side of the photovoltaic device.

Film 18 provides anti-reflective (AR) characteristics for the device. The transparent film can comprise a variety of materials, such as metal oxides. Non-limiting examples include silicon nitride (SiN), zinc oxide (ZnO), doped ZnO, and indium tin oxide (ITO). Film 18 can be formed by various conventional techniques, such as sputtering or evaporation. Its thickness will depend on various factors, including desired AR characteristics. Usually, transparent film 18 (which has a top surface 20) will have a thickness in the range of about 200 Angstroms to about 1000 Angstroms.

A second amorphous semiconductor layer 22 is disposed on a portion of the back surface 14 of substrate 10. While substrate 10 is the primary power generating layer of the photovoltaic device, semiconductor layer 22 constitutes a component of one of the electrodes of the device. As those skilled in the art understand, the electrodes are typically designed to carry the power (electrical current) through the device and out to an external circuit. Semiconductor layer 22 can be either n-type or p-type, depending upon the electrical configuration of the photovoltaic device.

According to a primary embodiment of the present invention, second amorphous layer 22 is compositionally graded, in terms of dopant concentration. In general, the dopant concentration is substantially zero at the interface with the substrate, i.e., region 24 in FIG. 1. On the opposite side of layer 22, i.e., region 26, the dopant concentration is at a maximum, in terms of semiconductor conductivity objectives. The concept of compositional grading for these types of layers is also generally described in a pending application assigned to the assignee of the present invention: U.S. Patent Application S.N. 11/263,159, filed on October 31, 2005, for J. Johnson and V. Manivannan. The contents of that patent application are incorporated herein by reference.

The term "compositionally-graded" is meant to describe a change (i.e., a "gradation") in dopant concentration as a function of the depth ("D") of semiconductor layer 22. In some embodiments, the gradation is substantially continuous, but this does not always have to be the case. For example, the rate-of-change in concentration may itself vary through the depth, increasing slightly in some regions, and decreasing slightly in others. (However, the overall gradation is always characterized as a decrease in dopant concentration in the direction toward substrate 10). Moreover, in some instances, the dopant concentration may remain constant for some portion of the depth, although that portion would probably be very small. Any and all of these variations in gradations are meant to be encompassed by the term "graded". The specific dopant concentration profile for a given semiconductor layer will depend on various factors, e.g., the type of dopant and the electrical requirements for the semiconductor device; as well as its microstructure and thickness.

As mentioned above, the dopant concentration for layer 22 is substantially zero at the interface with the substrate, regardless of the particular dopant profile. Thus, an intrinsic region 24 functions to prevent recombination of the charge-carriers at the interface with substrate surface 14. At the opposite, lower surface of amorphous layer 22, region 26 is substantially conductive. The specific dopant concentration in that region will depend on the particular requirements for the semiconductor device. As a non-limiting example in the case of a polycrystalline or single crystalline silicon substrate, region 26 will often have a concentration of dopant in the range of about 1 x 10¹⁶ cm⁻³ to about 1 x 10²¹ cm⁻³.

The thickness of graded amorphous layer 22 will also depend on various factors, such as the type of dopant employed; the conductivity-type of the substrate; the grading profile; and the dopant concentration in region 26. As in the case of layer 16, the thickness of layer 22 is usually less than or equal to about 250 Angstroms. In some specific embodiments, graded layer 22 has a thickness in the range of about 30 Angstroms to about 180 Angstroms. As described previously for layer 16, the most appropriate thickness in a given situation can readily be determined by taking measurements related to the photoelectric conversion efficiency of the device. Measurement of other properties (such as open circuit voltage (V_{oc}), short circuit current (I_{sc}), and fill factor (FF)) can also be helpful in determining the most appropriate thickness for layer 22.

In some preferred embodiments (though not all), an electrode layer 28 is formed on the backside of amorphous semiconductor layer 22 (FIG. 1) . Usually, electrode layer 28 functions as a diffusion barrier layer, preventing metal atoms from diffusing from a conductive layer (described below) into semiconductor layer 22. Electrode layer 28 is typically formed from a conductive material such as indium tin oxide, ZnO, doped ZnO, and the like. It can be formed from any of the typical deposition techniques used to deposit conductive layers. Layer 28 usually has a thickness in the range of about 50 Angstroms to about 500 Angstroms, although this range may vary considerably.

With continued reference to FIG. 1, a metal contact 30 is disposed over amorphous semiconductor layer 22. Metal contact 30 would be applied directly on layer 22, in the absence of intervening electrode layer 28. When layer 28 is present, metal layer 30 would be applied thereover. Metal contact 30 functions as a conducting electrode, conveying the electric current generated by the photovoltaic device to a desired location. The metal contact can be formed of a variety of conductive materials, such as silver (Ag), aluminum (Al), copper (Cu), molybdenum (Mo), tungsten (W), titanium (Ti), palladium (Pd), and various combinations thereof. Although metal contact 30 is illustrated as a layer of material in FIG. 1, its shape and size can vary considerably, as further described below. The metal contact can be formed by various techniques, e.g., plasma deposition, screen printing; vacuum evaporation (sometimes using a mask); pneumatic dispensing; or direct-write techniques such as ink jet printing.

A third amorphous semiconductor layer 32 is disposed on another portion of the back surface 14 of substrate 10. As in the case of layer 22, semiconductor layer 32 constitutes another component of one of the electrodes of the photovoltaic device. Layer 32 can be of the n-type or p-type. However, in most of the semiconductor configurations of this type, layer 32 has a conductivity (n or p) different from that of semiconductor layer 22. (In FIG. 1, layer 22 is arbitrarily depicted as n-type, while layer 32 is depicted as p-type).

As in the case of amorphous semiconductor layer 22, layer 32 is compositionally graded, in terms of dopant concentration. Thus, the dopant concentration is substantially zero at the interface with the substrate, i.e., region 34 in FIG. 1. This intrinsic region prevents recombination of the charge-carriers, as described previously. On the opposite side of layer 32, i.e., region 36, the dopant concentration is at a maximum, in terms of semiconductor conductivity objectives. As in the case of layers 22 and 16, the thickness of layer 32 is usually less than or equal to about 250 Angstroms. In some specific embodiments, the layer has a thickness in the range of about 30 Angstroms to about 180 Angstroms.

As in the case of region 26, region 36 will usually have a concentration of dopant in the range of about 1 x 10¹⁶ cm⁻³ to about 1 x 10²¹ cm⁻³. However, the specific concentration need not be identical to that of region 26, and will depend in part on the overall configuration of the device. Moreover, the overall gradation pattern for semiconductor layer 32 may be similar or substantially identical to that of semiconductor layer 22. However, in some embodiments, the gradation profiles can differ from each other - again depending on factors such as layer composition and thickness, dopant-type, semiconductor requirements, and the like. Moreover, it should be emphasized that the exact depth of "regions" 24, 26, 34, and 36 can vary, depending on factors discussed herein, such as semiconductor layer thickness and dopant profile. The same is true for the analogous regions depicted in the other figures.

In FIG. 1, the individual widths of semiconductor layers 22 and 32 are depicted as being equal to each other. (In the figure, the width dimension is designated with an arrow and the letter "W"). However, it is not necessary that the widths be equal. In some preferred embodiments, the width of the i-p-graded amorphous layer (here, An optional electrode layer 38 can be applied over the backside of amorphous semiconductor layer 32. Layer 38 performs in a manner similar to layer 28, e.g., functioning as a diffusion barrier layer between the underlying amorphous semiconductor layer and the metal contact described below. Electrode layer 38 is also typically formed from a conductive material. It can have the same thickness as layer 28, but in some embodiments, the thickness can differ as well.

A metal contact 40 is disposed over amorphous semiconductor layer 32, as depicted in FIG. 1. As in the case of metal contact 30, contact 40 would be applied directly on layer 32, or on top of optional layer 38. Metal contact 40 functions as another conducting electrode, conveying the electric current generated by the photovoltaic device to a desired location. The metal contact can be formed from the conductive materials described above, and is usually made from the same material as contact 30. Moreover, the size and shape of contact 40 can vary significantly, as can the manner in which it is formed. In other words, these parameters and details do not have to be the same as for contact 30, as they depend in large part on the overall construction of the photoelectric device.

As also shown in FIG. 1, second amorphous semiconductor layer 22 is spaced from third amorphous semiconductor layer 32 by an isolation trench 42. Typically, the primary function of trench 42 is to electrically and structurally isolate the two semiconductor layers, and/or to isolate contact layer 30 from contact layer 40. The precise shape of the trench can also vary. The trench can be formed by a number of conventional techniques - either during or after the fabrication of the various semiconductor and metal layers. As an example, the trench could be formed by drilling processes such as laser drilling, or by mechanical scribing techniques. In some instances, the trench is filled or partially filled with an electrically-insulating material, e.g., a polymeric resin (not shown here). The insulating material may serve to protect the underside of substrate 10 during various fabrication steps used to form the device, such as etching, milling, or scribing steps.

Contact layers 30 and 40 constitute a portion of an electrical system for interconnecting the various semiconductor elements. Any conventional electrical design may be used for such a system. As emphasized herein, preferred embodiments call for all of the electrical contacts to be incorporated into locations which ensure that the front surface of the device, i.e., top surface 20, is substantially free of any features which would obstruct incoming light. Typically, then, the various electrical interconnections are located in the general vicinity of substrate back surface 14, forming an "all-back-contact" configuration.

As one illustration, the contacts may be interdigitated. For example (and when viewed from a planar perspective for the device), the contacts may be arranged in a comb-shape, as described in U.S. Publication 2005/0062041 A1, which is incorporated herein by reference. Interdigitated arrangements are also described in various other references, e.g., U.S. Patent 5,053,083 (Sinton); 4,200,472 (Chappell et al); and Publication 2004/0200520 A1 (Mulligan et al), which are also incorporated herein by reference. Those skilled in the art will be able to readily determine the most appropriate metallization and electrical scheme for a particular device, without undue effort.

The compositional-grading of semiconductor layers 22 and 32 can be carried out by various techniques. The deposition of each layer is typically undertaken in separate steps. Usually, grading is accomplished by adjusting the dopant levels during plasma deposition. In a typical embodiment, a silicon precursor gas such as silane (SiH₄) is introduced into the vacuum chamber in which the substrate is situated. A diluting gas such as hydrogen may also be introduced with the silicon precursor gas. Flow rates for the precursor gas can vary considerably, but are typically in the range of about 10 sccm to about 300 sccm. During the initial stages of deposition, no dopant precursors are present. Therefore, regions 24 and 34 are substantially intrinsic ("undoped"), as mentioned above, thus serving to passivate the surface of substrate 10.

As the deposition process continues for each of layers 22 and 32, a dopant precursor is added to the plasma mixture. Choice of a precursor will of course depend on the selected dopant, e.g., n-type dopants such as phosphorus (P), arsenic (As), and antimony (Sb); or p-type dopants such as boron (B). Several non-limiting examples of dopant compounds can be provided: diborane gas (B₂H₆) for the p-type dopant, or phosphine (PH₃) for the n-type dopant. The dopant gases may be in pure form, or they may be diluted with a carrier gas, such as argon, hydrogen, or helium.

During the formation of each layer 22 and 32, the addition of the dopant gas is carefully controlled, to provide the desired doping profile. Those skilled in the art are familiar with gas metering equipment, e.g., mass flow controllers, which can be used to carry out this task. The feed rate for the dopant gas will be selected to substantially match the gradation scheme described above. Thus, in very general terms, the feed rate of the dopant gas will gradually increase during the deposition process. However, many specific changes in feed rate can be programmed into the deposition scheme. Maximum flow rates at the conclusion of this step of the process result in the formation of substantially-conductive regions 26 and 36, as mentioned previously. Each of regions 26 and 36 forms a heterojunction with the substrate.

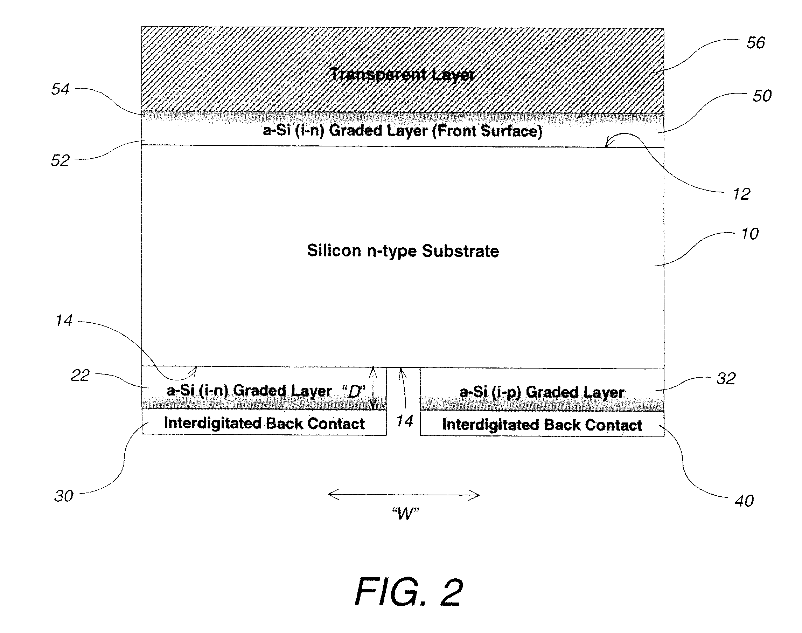

In the embodiment of FIG. 1, an intrinsic amorphous silicon layer was formed on the front surface of the substrate. However, in other embodiments, a compositionally-graded amorphous semiconductor layer is formed in place of the intrinsic layer. One illustration of this alternative embodiment is depicted in FIG. 2. (In this figure, many of the elements similar or identical to those of FIG. 1 are not labeled, or are provided with the same element numerals). Thus, as shown in FIG. 2, a first amorphous semiconductor layer 50 is disposed on the front surface 12 of substrate 10. The first amorphous semiconductor layer is compositionally graded through its depth. Thus, the layer is substantially intrinsic at the interface with the substrate (i.e., region 52), and substantially conductive at the opposite side (region 54).

Layer 50 can be compositionally graded according to the same techniques described previously, for the graded layers of FIG. 1. Moreover, the graded profile for layer 50 may be similar to that of the other graded layers, though it can have a different profile as well. Usually, the conductive region of the layer (i.e., region 54) will have a concentration of dopant atoms in the general range described previously, i.e., about 1 x 10¹⁶ cm⁻³ to about 1x10²¹ cm⁻³. The type of dopant used for graded layer 50 will depend in part on the conductivity-type of the substrate. Typically, the layer forms a heterojunction with the substrate.

As in the case of the other doped regions, the specific dopant concentration profile for layer 50 will depend on various factors, e.g., the type of dopant and the electrical requirements for the semiconductor device; as well as its microstructure and thickness. The presence of compositionally graded layer 50 can be very advantageous as an additional site for preventing recombination of charge carriers. In this manner, the intended path of the charge carriers toward the collection electrodes of the device is enhanced, thereby resulting in greater photoelectric conversion. Layer 50 can be referred to as a front surface field (FSF).

As in the embodiment of FIG. 1, a transparent film or layer 56 is disposed on top of amorphous semiconductor layer 50 in FIG. 2, providing anti-reflective characteristics for the device. Moreover, the device also includes second and third amorphous semiconductor layers 22, 32, formed on the back surface 14 of the substrate. In preferred embodiments, each of these layers is compositionally graded, as described previously.

With continued reference to FIG. 2, metal contact layers 30 and 40 are formed over layers 22 and 32, respectively. In this particular illustration, there are no electrode layers between the metal contact layers and underlying amorphous layers 22 and 32 (i.e., analogous to layers 28 and 38 in FIG. 1). However, it should be understood that the electrode layers could also be utilized in this embodiment as well, e.g., to perform as a diffusion barrier.

In some preferred embodiments of the present invention, at least one of the planar surfaces of the semiconductor device is textured. Texturing of the various surfaces of the device can reduce undesirable light reflection. Moreover, texturing can utilize incoming light much more effectively, by elongating an optical path length in one of the semiconductor layers ("optical light trapping"). Usually, at least the front-side (i.e., the surface closest to incident light) is textured.

Texturing can be carried out by a variety of techniques. One instructive source of information is an article by David King et al, "Experimental Optimization of an Anisotropic Etching Process for Random Texturization of Silicon Solar Cells", IEEE Conference Proceedings (1991), pages 303-308. This article is incorporated herein by reference. Very often, texturing can be carried out by etching techniques, using mild alkaline solutions with low concentrations (e.g., less than about 5% by volume) of basic compounds like potassium hydroxide or sodium hydroxide. The alkaline solutions can contain other components as well, e.g., hydroxy compounds such as isopropyl alcohol. Many other types of alkaline solutions may also be employed.

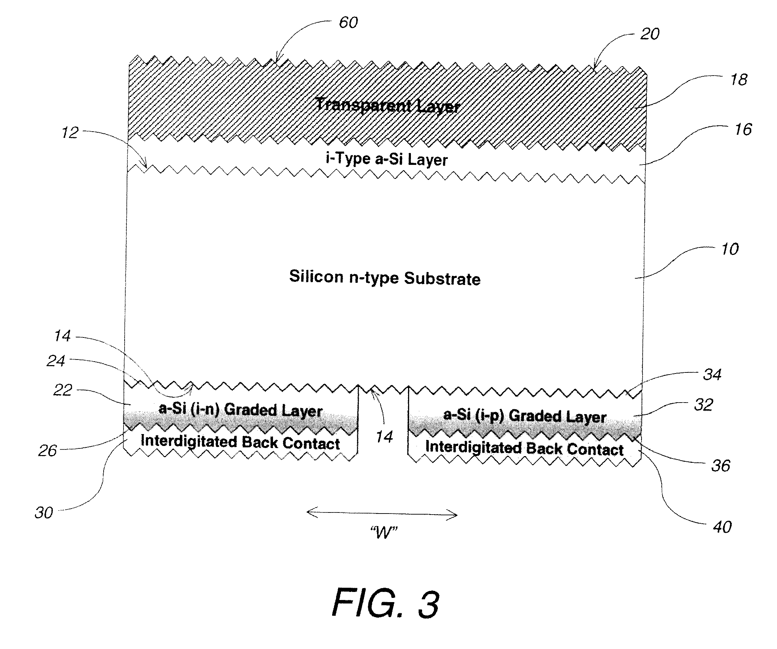

Fig 3 is a non-limiting illustration of a semiconductor device for some of these preferred embodiments. (In this figure, many of the elements similar or identical to those of FIG. 1 are not labeled, or are provided with the same element numerals). In some preferred embodiments, the front surface 12 of the substrate is textured, as shown in FIG. 3. Moreover, back surface 14 can be textured.

The type of texturing can vary considerably, depending on a number of factors discussed previously. As one example, textured features can be in the form of microscopic pyramids 60, as shown in FIG. 3. It should be emphasized that FIG. 3 happens to show all planar surfaces as being textured, although there is no requirement or preference for that to be the case. As those skilled in the art understand, the textured profile for many of the surfaces can effectively result from the profile of the underlying surfaces. For example, if substrate surfaces 12 and 14 are textured, layers deposited over those surfaces (and layers thereafter) will often adapt the conformal features of the substrate surfaces. For example, this is shown in FIG. 3 for semiconductor layers 16, 22, 32; transparent layer 18; and metallic contact layers 30, 40. (The optional electrode layers, e.g., layers 28 and 38 in FIG. 1, can also be textured, when present).

Various other details regarding the texturing of semiconductor layers for photovoltaic devices are known in the art. As one example, U.S. Patent 6,670,542 (Sakata et al) describes steps in forming textured surfaces for single crystalline layers used in photovoltaic conversion devices. The Sakata et al patent is also incorporated herein by reference. Moreover, Sakata et al describes procedures which are helpful in ensuring that i-type amorphous layers (like those described herein) are formed on textured surfaces with the desired degree of layer-uniformity.

The discussion above relates to semiconductor structures which are often used as solar cell devices. One or more of these devices can be incorporated into the form of a solar module. For example, a number of the solar cells can be electrically connected to each other, in series or in parallel, to form the module. (Those of ordinary skill in the art are familiar with details regarding the electrical connections, etc). Such a module is capable of much greater energy output than the individual solar cell devices.

Non-limiting examples of solar modules are described in various references, e.g., U.S. Patent 6,667,434 (Morizane et al), which is incorporated herein by reference. The modules can be formed by various techniques. For example, a number of solar cell devices can be sandwiched between glass layers, or between a glass layer and a transparent resin sheet, e.g., those made from EVA (ethylene vinyl acetate). Thus, according to some embodiments of this invention, solar modules contain at least one solar cell device which itself comprises a compositionally-graded amorphous layer adjacent a semiconductor substrate, as described previously. The use of the graded layers can improve device properties like photoelectric conversion efficiency, etc., and thereby improve the overall performance of the solar module.

The Morizane et al reference also describes various other features for some of the solar modules. For example, the patent describes "two-side incidence"-type solar modules in which light can contact both front and rear surfaces of the module. Moreover, the patent describes solar modules which must be extremely moistureproof (e.g., those used outdoors). In these types of modules, sealing resins can be used to seal the side of each solar cell element. Furthermore, the modules may include various resinous layers which prevent the undesirable diffusion of sodium from nearby glass layers. All of these types of solar modules may incorporate devices which comprise the compositionally-graded amorphous layer (or layers) described herein.

Those skilled in the art are generally familiar with many other details regarding the primary components of the solar modules, e.g., the various substrate materials, backing materials, and module frames. Other details and considerations are also well-known, e.g., wire connections in and out of the module (for example, those leading to an electrical inverter); as well as various module encapsulation techniques.

### EXAMPLES

A general example is provided below. It should be viewed as merely illustrative, and should not be construed to be any sort of limitation on the scope of the claimed invention.

The fabrication of photovoltaic devices according to some embodiments of the present invention can be undertaken as follows: Monocrystalline or polycrystalline semiconductor substrates (or silicon wafers) of one conductivity type can first be etched by conventional techniques. For example, a texturing solution containing selected proportions of ultra-pure deionized water, potassium hydroxide (KOH, 45% concentration), and isopropyl alcohol can first be prepared in a quartz vessel. The temperature of the texturing solution is usually maintained at about 65°C - 80°C. The substrate can then be immersed in the agitated solution for a period of time determined to be suitable to achieve the desired degree of etching (typically about 5-60 minutes). Following the texturing step, the substrate is removed and rinsed with deionized water.

In some instances, the substrate is subjected to various pre-treatment steps, prior to texturing. For example, the substrate (e.g., a wafer) can be immersed in a buffer-oxide-etch (BOE) solution for 60 seconds, followed by a surface damage-removal etch. The latter step can be carried out in a 1 : 1 solution of KOH : H₂O solution for 30 minutes at 85°C, and can result in the desired thinning of the substrate by about 30 microns. The wafer can then be stored in isopropyl alcohol for at least 10 minutes, to prevent surface oxidation.

With reference to the exemplary embodiment of FIG. 3, the substrate 10 can then be placed in a plasma reaction chamber (for example: a plasma enhanced chemical vapor deposition system), in preparation for the formation of the features on the front side of the device. A vacuum pump is used to remove atmospheric gases from the chamber, and the substrate is then pre-heated to about 120 to about 240°C. An optional hydrogen plasma surface preparation step is performed on the front surface of the substrate. Hydrogen (H₂) is introduced into the chamber at a flow rate of about 50 to about 500 seem (standard cubic centimeters per minute). A throttle valve is used to maintain a constant processing pressure in the range of about 200 mTorr to about 800 mTorr. Alternating frequency input power with a power density in the range of about 6 mW/cm² to about 50 mW/cm² range is used to ignite and maintain the plasma. Applied input power can be from about 100 kHz to about 2.45 GHz. Hydrogen plasma surface preparation time is about 1 to about 60 seconds.

At the end of the hydrogen plasma preparation step (if such a step is employed), silane (SiH₄) is introduced into the process chamber at a flow rate of about 10 seem to about 300 seem. This will initiate the deposition of the intrinsic amorphous silicon layer 16. ( In this embodiment, there are no dopant precursors included in the plasma, so that the composition of the amorphous layer is intrinsic (undoped), thus serving to passivate the surface of the semiconductor substrate). Deposition continues until the intrinsic layer achieves the desired, average thickness. As described above, the layer usually conforms to the surface profile of the underlying substrate, and would thus also have a textured surface.

After formation of intrinsic layer 16, transparent anti-reflective layer or coating 18 can be formed within a suitable process chamber. As mentioned previously, a number of techniques can be used to form such a layer, such as sputtering, CVD, evaporation, and the like. Deposition continues until layer 18 has a desired thickness. As in the case of layer 16, layer 18 will usually conform closely to the underlying surface, thus resulting in a textured uppermost surface 20.

Substrate 10 can then be repositioned in the vacuum chamber, in preparation for the formation of all of the backside features. There are a number of details regarding formation of each of the backside amorphous layers, as well as the overlying metal contacts, and intervening, optional electrode layers. There is no need to elaborate on the many steps involved in the formation of these layers, since they are very conventional to the semiconductor industry. As those skilled in the art understand, the formation of the various layers on the backside involves a serious of deposition and photolithographic steps, e.g., masking, curing (exposure), photoresist lift-off, etching, and the like.

A brief review will be undertaken in regard to formation of graded layers 22 and 32. (The steps in their formation can be substantially equivalent, although different dopant atoms are used to provide the different conductivity types). As described for the front side of the device, a hydrogen plasma preparation step may first be undertaken on the backside, in which silane is introduced into the process chamber at a flow rate of about 10 seem to about 300 seem. This will result in the formation of intrinsic amorphous regions 24 and 34 (depending on which layer is being formed first). In each instance, the absence of dopant precursors functions to passivate the back surface 14 of the substrate.

As the deposition process for each of layers 22 and 32 progresses, the desired dopant precursor is subsequently added to the plasma mixture. Examples of dopant precursors are: B₂H₆, B(CH₃)₃, and PH₃. These may be in pure form or diluted with a carrier gas such as argon, hydrogen or helium. The flow rate of the precursor is increased over the course of the compositionally-graded layer deposition. This forms a gradient in the doping concentration through the single layer. At the conclusion of the graded layer deposition process, concentrations of dopant precursor in the plasma are such that substantially doped amorphous semiconductor properties are achieved, i.e., in regions 26 and 36.

Electrode layers 28 and 38 (if present) can then be formed over the respective, graded layers, according to one or more of the techniques described previously, such as sputtering. Contacts 30 and 40 can also be formed in the conventional manner, e.g., by screen-printing. Isolation trench 42 can also be formed in known fashion, e.g., by laser-drilling or mechanical scribing. Those skilled in the art will be familiar with other conventional fabrication steps for the device as well. Moreover, the patents and other references set forth above provide further details regarding the manufacture of modules which contain multiple devices of this type.

Although the present invention has been described and illustrated in detail, it should be clearly understood that the description discloses examples of different embodiments of the invention, and is not intended to be limited to the examples or illustrations provided. Accordingly, various modifications, adaptations, and alternatives may occur to one skilled in the art without departing from the scope of the claimed inventive concept. All of the patents, patent applications, articles, and texts which are mentioned above are incorporated herein by reference.

## Claims

1. A semiconductor structure, comprising:
(a) a semiconductor substrate (10) of one conductivity type, having a front surface (12) and a back surface (14);
(b) a first amorphous semiconductor layer (16) disposed on the front surface (12) of the semiconductor substrate (10);
(c) a second amorphous semiconductor layer (22) disposed on a portion of the back surface (14) of the semiconductor substrate (10), wherein the second amorphous semiconductor layer (22) is compositionally graded through its depth, from substantially intrinsic at the interface with the substrate (10), to substantially conductive at the opposite side, said second amorphous semiconductor layer (22) having a selected conductivity type obtained by the incorporation of selected dopant atoms; and
(d) a third amorphous semiconductor layer (32) disposed on another portion of the back surface (14) of the semiconductor substrate (10), and spaced from the second amorphous semiconductor layer (22), wherein the third amorphous semiconductor layer (32) is compositionally graded through its depth, from substantially intrinsic at the interface with the substrate (10), to substantially conductive at the opposite side, said third amorphous semiconductor layer(32) having a conductivity type different from that of the second amorphous layer (22), and obtained by the incorporation of selected dopant atoms.

2. The semiconductor structure of claim 1, wherein for both the second amorphous semiconductor layer (22) and the third amorphous semiconductor layer (32), the concentration of dopant atoms at the interface with the substrate (10) is substantially zero; and the concentration of dopant atoms at the opposite side is in the range of about 1 x 10¹⁶ cm to about 1 x 10²¹ cm⁻³.

3. The semiconductor structure of claim 1 or claim 2, wherein at least one electrical contact (30) is disposed over the second amorphous semiconductor layer (22), and at least one electrical contact (40) is disposed over the third amorphous semiconductor layer (32).

4. The semiconductor structure of claim 3, wherein an electrode layer (28) is disposed between the second amorphous semiconductor layer (22) and its overlying electrical contact (30); and an electrode layer (38) is disposed between the third amorphous semiconductor layer (32) and its overlying electrical contact (40).

5. The semiconductor structure of any preceding claim, wherein the second amorphous semiconductor layer (22) is spaced from the third amorphous semiconductor layer (32) by an isolation trench (42).

6. The semiconductor structure of any preceding claim, wherein a transparent layer (18) is disposed on the first amorphous semiconductor layer (16).

7. The semiconductor structure of claim 6, wherein the transparent layer (18) comprises an anti-reflective structure.

8. The semiconductor structure of claim 6, wherein the transparent layer (18) is formed of a material comprising silicon nitride.

9. The semiconductor structure of any preceding claim, wherein the substrate (10) is monocrystalline or polycrystalline; and is n-type or p-type.

10. The semiconductor structure of any preceding claim, wherein the first amorphous semiconductor layer (16) is intrinsic.

11. The semiconductor structure of any one of claims 1 to 9, wherein the first amorphous semiconductor layer (16) is compositionally graded through its depth, from substantially intrinsic at the interface with the substrate (10), to substantially conductive at the opposite side.

12. The semiconductor structure of any preceding claim, wherein the front surface (12) of the substrate (10) is textured.

13. The semiconductor structure of claim 3, wherein at least one electrical contact (30) disposed on the second amorphous semiconductor layer (22) is interdigitated with at least one electrical contact (40) disposed on the third amorphous semiconductor layer (32).

14. A solar cell, comprising a semiconductor structure having an all-back-contact configuration, wherein at least one amorphous semiconductor layer of the structure comprises a compositionally-graded dopant atom profile.

15. A method for making a photovoltaic device, comprising the steps of:
(I) forming a first amorphous semiconductor layer (16) over a front surface (12) of a semiconductor substrate (10);
(II) forming a second amorphous semiconductor layer (22) on a portion of a back surface (14) of the semiconductor substrate (10), by depositing semiconductor material and a dopant over the back surface portion, while altering the concentration of the dopant, so that the second amorphous semiconductor layer (22) becomes compositionally-graded through its depth, from substantially intrinsic at the interface with the back surface (14) of the substrate, to substantially conductive at the opposite side; and
(III) forming a third amorphous semiconductor layer (32) on another portion of the back surface (14) of the semiconductor substrate (10), by depositing semiconductor material and a dopant over the back surface portion, while altering the concentration of the dopant, so that the third amorphous semiconductor layer (32) becomes compositionally-graded through its depth, from substantially intrinsic at the interface with the back surface (14) of the substrate (10), to substantially conductive at the opposite side.
